# EUROPEAN PATENT APPLICATION

(11) **EP 4 582 184 A1**
(43) Date of publication of application: **09.07.2025**
(21) Application number: 23870835.8
(22) Date of filing: 26.09.2023
(51) Int. Cl.: B01L 3/00

(54) **MICROFLUIDIC CHIP, PREPARATION METHOD THEREFOR, AND MICROFLUIDIC SYSTEM**

(30) Priority: 26.09.2022 CN 202211176002
(71) Applicant: Jiangsu Logilet Biotech Co., Ltd., Suzhou, Jiangsu 215300 (CN)
(72) Inventor: SU, Yang, Suzhou, Jiangsu 215300 (CN); ZHANG, Yan, Suzhou, Jiangsu 215300 (CN)
(74) Representative: Laufhütte, Dieter
(86) International application number: PCT/CN2023/121626
(87) International publication number: WO 2024/067607

(57) **Abstract**

A microfluidic chip (1001) and a preparation method therefor, and a microfluidic system (1000). The microfluidic chip (1001) includes a first substrate (100), a second substrate (200), and a gap control layer (300) located between the first substrate (100) and the second substrate (200), wherein the gap control layer (300) comprises an adhesive line (301) and a plurality of gap beads (302) of substantially the same size arranged at intervals in the adhesive line (301). Providing the plurality of gap beads (302) of substantially the same size arranged at intervals in the adhesive line (301) allows for highly accurate control of a gap between the first substrate (100) and the second substrate (200).

## Description

### Cross-References

The present application refers to Chinese Patent Application No. 202211176002.7, filed on September 26, 2022 and entitled "MICROFLUIDIC CHIP AND PREPARATION METHOD THEREFOR, AND MICROFLUIDIC SYSTEM", which is incorporated herein by reference in its entirety.

### Technical Field

The disclosure relates to the technical field of microfluidics, and in particular to a microfluidic chip and a preparation method therefor, and a microfluidic system.

### Background Art

Microfluidics is technology that integrates basic operation units of sample preparation, reaction, separation, test, etc. during biological, chemical and medical analysis processes into a micron-scale chip to automatically complete the whole process of analysis. Owing to its great potential in the fields of biology, chemistry, medicine and the like, it has been developed into a new research field that involves the disciplines of biology, chemistry, medicine, fluidics, electronics, materials, mechanics, etc.

The fluid control principle of microfluidic chips is to, based on the electrowetting technology, control solid-liquid interface energy by electric potential and use the asymmetry of a contact angle of a droplet to generate a tangential push force, which causes asymmetric deformation at two ends of the droplet to promote generation of a pressure difference inside the droplet, so as to achieve the purpose of precise control of micro liquid. With the breakthroughs made in material science, micro-nano fabrication technology and microelectronics, microfluidic chips have also been developed rapidly, but manufacturing is still a bottleneck hindering the development of the microfluidics technology. How to improve the manufacturing accuracy of the microfluidic chip to achieve precise control and accurate analysis of droplets is an important direction of development of microfluidic chips. During the charge and discharge of a battery, battery cells will swell, which impairs the safety performance of the battery. In addition, with the charge-discharge cycles of the battery, an electrolyte is continuously consumed, affecting the service life of the battery.

### Summary

The disclosure is intended to solve at least one of the technical problems existing in the prior art. To this end, an objective of the disclosure is to provide a microfluidic chip and a preparation method therefor, and a microfluidic system, in order to improve the manufacturing accuracy of the microfluidic chip.

In a first aspect of the disclosure, an embodiment provides a microfluidic chip, including: a first substrate, a second substrate and a gap control layer, the second substrate being arranged facing and spaced apart from the first substrate, the gap control layer being located between the first substrate and the second substrate, and the gap control layer including an adhesive line and a plurality of gap beads of substantially the same size arranged at intervals in the adhesive line.

Providing the plurality of gap beads arranged at intervals in the adhesive line between the first substrate and the second substrate enables control of a gap between the first substrate and the second substrate based on the size of the gap beads. Since the dimensional uniformity of the gap beads can be ensured by means of improving the machining accuracy, the dimensional uniformity of the gap between the first substrate and the second substrate can be ensured to achieve accuracy control and test analysis of droplets, thereby improving the yield and test accuracy of the microfluidic chip.

In some embodiments, the first substrate includes a hydrophobic dielectric functional layer, the adhesive line is arranged along an outer edge of the hydrophobic dielectric functional layer, and the outer edge of the hydrophobic dielectric functional layer falls within the range of the adhesive line.

The adhesive line is arranged along the outer edge of the hydrophobic dielectric functional layer, and also the outer edge of the hydrophobic dielectric functional layer falls within the area of the adhesive line, such that the adhesive line can seal the edge of the hydrophobic dielectric functional layer, which avoids affecting the test effect due to leakage of medium oil or reaction reagents or due to entry of external impurities and also prevents shedding of the hydrophobic dielectric functional layer due to immersion in liquid, thereby improving the stability of quality of the microfluidic chip.

In some embodiments, the gap beads are arranged outside the outer edge of the hydrophobic dielectric functional layer.

Arranging the gap beads at positions staggered with the hydrophobic dielectric functional layer can avoid non-uniformity of height of the gap due to some of the gap beads being placed on the hydrophobic dielectric functional layer, and can also avoid affecting the uniformity of the gap due to the low accuracy of surface of the hydrophobic dielectric functional layer.

In some embodiments, the first substrate includes a circuit board and a hydrophobic dielectric functional layer, the circuit board including a substrate and an electrode located on the substrate, and the hydrophobic dielectric functional layer being arranged on a surface of the electrode close to the second substrate; and the second substrate includes a conductive cover plate and a hydrophobic layer facing each other, a droplet movement space being formed between the hydrophobic dielectric functional layer and the hydrophobic layer.

Arranging the droplet movement space between the hydrophobic dielectric functional layer of the first substrate and the hydrophobic layer of the second substrate can reduce the surface tension of the droplets to enable the droplets to move accurately under the control of the electrode, thereby improving the test efficiency.

In some embodiments, the hydrophobic dielectric functional layer is a single-layer hydrophobic dielectric composite layer, and the hydrophobic dielectric composite layer is bonded to the surface of the electrode close to the second substrate by means of an adhesive layer.

The functions of a hydrophobic layer and a dielectric layer are achieved by one film, such that the number and thickness of film layers on the surface of the electrode are reduced, which shortens the time for preparation of the film layer and avoids affecting the movement and test of the droplets due to deterioration of flatness caused by stacking of multiple film layers.

In some embodiments, the hydrophobic dielectric functional layer has a first pattern, and the hydrophobic layer has a second pattern that is a mirror image of the first pattern, the first pattern and the second pattern jointly defining the droplet movement space.

An area of the droplet movement space can be defined by means of providing the first pattern and the second pattern that are mirror images of each other, and an area of the adhesive line is reserved outside the droplet movement space, which facilitates guiding the subsequent adhesive dispensing to avoid insufficient sealing caused by leakage of adhesive.

In some embodiments, the gap control layer further includes at least one support adhesive block located within the outer edge of the hydrophobic dielectric functional layer and abutting against the first substrate and the second substrate, with a projection of the at least one support adhesive block on the first substrate being staggered with the electrode on the first substrate.

The support adhesive block is arranged in the droplet movement space, which can form better support between the first substrate and the second substrate, such that the microfluidic chip receives force more uniformly and has a more stable structure, thereby prolonging the service life of the microfluidic chip. The support adhesive block is staggered with the electrode, which can avoid affecting the movement of the droplets to ensure the accuracy of control of the droplet movement.

In some embodiments, the hydrophobic dielectric functional layer further has a third pattern that is at least one hollowed-out area for accommodating the at least one support adhesive block, and at least one gap bead is provided in any one of the at least one support adhesive block.

The hollowed-out area is formed on the hydrophobic dielectric functional layer to arrange the support adhesive block, and the gap bead is placed in the support adhesive block, which can provide better support for the microfluidic chip to avoid affecting the uniformity of height of the gap caused by the formation of bulge due to deformation of the middle of the first substrate in the droplet movement space to some extent.

In some embodiments, the gap bead located in the at least one support adhesive block is of substantially the same size as the gap beads located in the adhesive line.

Setting the size of the gap bead in the support adhesive block to be substantially the same as the size of the gap beads in the adhesive line is conducive to controlling the height of the gap at the position where the support adhesive block is located to be substantially consistent with the size of the gap beads and thus be consistent with the height of the gap at other positions of the microfluidic chip, which further ensures the uniformity of height of the gap while applying uniform force to the microfluidic chip.

In some embodiments, an edge of the third pattern is at least partially located within the range of the at least one corresponding support adhesive block, and a projection of the gap bead arranged in any one of the at least one support adhesive block on the first substrate is located outside a range of the hydrophobic dielectric functional layer.

In some embodiments, the gap bead has a diameter of 800 ± 5 microns.

In some embodiment, the droplet movement space has a height greater than or equal to 710 microns and less than or equal to 740 microns.

According to the requirement on the test accuracy and the need of the droplet flux of the microfluidic chip, selecting an appropriate size of the gap bead and an appropriate tolerance range can not only meet the functional needs of the microfluidic chip but also consider both the manufacturing cost and the manufacturing process, thereby improving the economic efficiency of mass production.

In a second aspect of the disclosure, an embodiment provides a method for preparing a microfluidic chip, the method including:
providing a first substrate,
preparing a gap control layer on a surface of one side of the first substrate, where the gap control layer includes an adhesive line and a plurality of gap beads of substantially the same size arranged at intervals in the adhesive line,
providing a second substrate,
placing the second substrate on the gap control layer for alignment with the first substrate to form a cell, and
curing the gap control layer.

Providing the plurality of gap beads of substantially the same size arranged at intervals in the adhesive line allows for highly accurate control of the gap between the first substrate and the second substrate, thereby improving the manufacturing accuracy of the microfluidic chip to ensure the controllability of droplet movement and the accuracy of the test result.

In some embodiments, preparing a gap control layer on a surface of one side of the first substrate includes: dispensing an adhesive along a surface of one side of the first substrate to form an adhesive line; and placing a plurality of gap beads of substantially the same size at intervals in the adhesive line.

Compared with the process of first mixing the gap beads with adhesive and then applying the mixture to the surface of the first substrate, by first dispensing an adhesive on the surface of the first substrate to form the adhesive line and then placing the gap beads of substantially the same size in the adhesive line at intervals. On the one hand, the adhesive line is positioned to enable positioning for placement of the gap beads, and the adhesive line has a viscosity that ensures the gap beads to be not easy to have a position shift after the placement of the gap beads, so as to enable the gap beads to be roughly and stably distributed within the range of the entire adhesive line. On the other hand, the positions of the gap beads can be subjectively set and can be flexibly adjusted as needed, which avoids being unable to control the arrangement positions of the gap beads during the mixed application, thereby improving the uniformity of the gap of the droplet movement space throughout the microfluidic chip.

In some embodiments, providing a first substrate includes:
providing a circuit board, and
preparing a hydrophobic dielectric functional layer on the circuit board;
providing a second substrate includes:
   providing a conductive cover plate, and
   preparing a hydrophobic layer on the conductive cover plate; and
   placing the second substrate on the gap control layer for alignment with the first substrate to form a cell includes:
      covering the second substrate over the gap bead of the gap control layer in such a way that the side of the second substrate where the hydrophobic layer is located faces the side of the first substrate where the hydrophobic dielectric functional layer is located, a droplet movement space being formed between the hydrophobic dielectric functional layer and the hydrophobic layer.

Separately preparing the first substrate and the second substrate and then aligning them to form a cell can improve the production efficiency of the microfluidic chip, covering the second substrate over the gap beads can ensure the dimensional uniformity of the gap, and the droplet movement space being located between the hydrophobic dielectric functional layer and the hydrophobic layer after forming a cell enables the droplets to move smoothly, thereby improving the droplet test efficiency.

In some embodiments, dispensing an adhesive along a surface of one side of the first substrate to form an adhesive line includes: dispensing an adhesive along an outer edge of a hydrophobic dielectric functional layer on a surface of one side of the first substrate to form an adhesive line, the outer edge of the hydrophobic dielectric functional layer falling within the range of the adhesive line.

The adhesive line is arranged along the outer edge of the hydrophobic dielectric functional layer to allow the liquid movement space to form a sealed chamber, such that the adhesive line can seal the edge of the hydrophobic dielectric functional layer, which avoids affecting the test effect due to leakage of medium oil or reaction reagents or due to entry of external impurities, thereby improving the stability of quality of the microfluidic chip. In addition, by means of covering the outer edge of the hydrophobic dielectric functional layer with the adhesive line, the edge position can be well sealed to avoid shedding of the hydrophobic dielectric functional layer due to the outer edge being exposed to the droplets.

In some embodiments, the gap beads are arranged outside the outer edge of the hydrophobic dielectric functional layer.

Arranging the gap beads outside the range of the hydrophobic dielectric functional layer can ensure that the gap is not affected by the thickness of the hydrophobic dielectric functional layer, thereby improving the uniformity of the gap of the microfluidic chip.

In some embodiments, preparing a hydrophobic dielectric functional layer on the circuit board includes: preparing a film for forming a hydrophobic dielectric functional layer, on a surface of one side of the circuit board where an electrode is provided, and patterning the film to form the hydrophobic dielectric functional layer.

Preparing a hydrophobic layer on the conductive cover plate includes: preparing a hydrophobic layer on a surface of one side of the conductive cover plate, an outer edge of a pattern of the hydrophobic layer being a mirror image of an outer edge of a pattern of the hydrophobic dielectric functional layer.

In some embodiments, preparing a hydrophobic dielectric functional layer on the circuit board further includes:
forming the hydrophobic dielectric functional layer having a first pattern and a third pattern that is staggered with the first pattern and the electrode, the third pattern being at least one hollowed-out area.
Preparing a hydrophobic layer on the conductive cover plate includes: forming the hydrophobic layer having a second pattern that is a mirror image of the first pattern and that defines the droplet movement space with the first pattern.
Preparing a gap control layer further includes: dispensing an adhesive in the at least one hollowed-out area of the third pattern to form at least one support adhesive block, and placing at least one gap bead in any one of the at least one support adhesive block.

The hollowed-out area is formed on the hydrophobic dielectric functional layer to arrange the support adhesive block, and the gap bead is placed in the support adhesive block, which can provide better support for the microfluidic chip to avoid affecting the uniformity of height of the gap caused by the formation of bulge due to deformation of the middle of the first substrate in the droplet movement space.

In some embodiments, the gap bead located in the at least one support adhesive block is of substantially the same size as the gap beads located in the adhesive line.

Setting the size of the gap bead in the support adhesive block to be substantially the same as the size of the gap bead in the adhesive line is conducive to controlling the height of the gap at the position where the support adhesive block is located to be consistent with the size of the gap beads and thus be consistent with the height of the gap at other positions of the microfluidic chip, which further ensures the uniformity of height of the gap while applying uniform force to the microfluidic chip.

In some embodiments, an edge of the third pattern is at least partially located within the range of the at least one corresponding support adhesive block, and a projection of the gap bead on the first substrate is located outside the range of the hydrophobic dielectric functional layer.

Arranging the gap beads at positions staggered with the hydrophobic dielectric functional layer can avoid non-uniformity of height of the gap due to the different gap beads being staggered in position, and can also avoid affecting the uniformity of the gap due to the low accuracy of surface of the hydrophobic dielectric functional layer.

In some embodiments, prior to curing the gap control layer, the method further includes: applying a preset pressure to an outer surface of the first substrate and an outer surface of the second substrate.

After the first substrate and the second substrate are aligned and prior to the gap control layer is cured, the preset pressure is applied to the outer surfaces of the first substrate and the second substrate, the gap beads will be pressed toward the first substrate and the second substrate to ensure the uniformity of the gap between the first substrate and the second substrate throughout the microfluidic chip.

In a third aspect of the disclosure, an embodiment provides a microfluidic system, including a control module and a microfluidic chip according to any one of the above embodiments or a microfluidic chip prepared by the method according to any one of the above embodiments, the control module being electrically connected to the microfluidic chip to control an electrical signal provided to the microfluidic chip.

The above description is merely a summary of the technical solutions of the present application. To make the technical means of the present application more clearly understood and implemented according to the contents of the specification, and to make the above and other objectives, features, and advantages of the present application more obvious and comprehensible, the embodiments of the present application are described in detail below.

### Brief Description of the Drawings

In figures, the same reference signs denote the same or similar components or elements throughout multiple figures, unless otherwise specified. These figures are not necessarily drawn to scale. It should be understood that these figures depict only some implementations disclosed according to the present application and are not to be construed as limiting the scope of the present application.
FIGS. 1 and 2 are schematic structural diagrams of a microfluidic chip according to some embodiments of the disclosure;
FIG. 3 is a schematic structural diagram of the microfluidic chip according to some embodiments of the disclosure from another perspective;
FIG. 4 is a schematic structural diagram of a first substrate of the microfluidic chip according to some embodiments of the disclosure;
FIG. 5 is a schematic structural diagram of a second substrate of the microfluidic chip according to some embodiments of the disclosure;
FIG. 6 is a schematic flowchart of a method for preparing a microfluidic chip according to some embodiments of the disclosure; and
FIG. 7 is a schematic structural diagram of a microfluidic system according to some embodiments of the disclosure.

List of reference signs:
1000 - microfluidic system, 1001 - microfluidic chip, 1002 - control module, 100 - first substrate, 101 - circuit board, 1011 - substrate, 1012 - electrode, 102 - hydrophobic dielectric functional layer, 1021 - first pattern, 1022 - third pattern, 103 - adhesive layer, 200 - second substrate, 201 - conductive cover plate, 202 - hydrophobic layer, 2021 - second pattern, 300 - gap control layer, 301 - adhesive line, 302 - gap bead, 303 - droplet movement space, 304 - support adhesive block.

### Detailed Description of Embodiments

The embodiments of the technical solutions of the disclosure will be described in detail below with reference to the accompanying drawings. The following embodiments are merely intended to more clearly illustrate the technical solutions of the disclosure, so they merely serve as examples, but are not intended to limit the scope of protection of the disclosure.

Unless otherwise defined, all technical and scientific terms used herein have the same meanings as those commonly understood by those skilled in the art to which the disclosure belongs. The terms used herein are merely for the purpose of describing specific embodiments, but are not intended to limit the disclosure. The terms "comprising" and "having" and any variations thereof in the specification and the claims of the disclosure and in the brief description of the accompanying drawings described above are intended to cover non-exclusive inclusion.

In the description of the embodiments of the disclosure, the technical terms "first", "second", etc. are merely used to distinguish different objects, and should not be construed as indicating or implying the relative importance or implicitly indicating the number, the specific order or the primary-secondary relationship of the technical features indicated. In the description of the embodiments of the disclosure, the phrase "a plurality of" means two or more, unless otherwise explicitly and specifically defined.

The phrase "embodiment" mentioned herein means that the specific features, structures, or characteristics described with reference to the embodiments can be encompassed in at least one embodiment of the disclosure. This phrase in various places in the specification does not necessarily refer to the same embodiment or an independent or alternative embodiment exclusive of other embodiments. It should be appreciated explicitly or implicitly by those skilled in the art that the embodiments described herein can be combined with other embodiments.

In the description of the embodiments of the disclosure, the term "and/or" is merely intended to describe the associated relationship of associated objects, indicating that three relationships can exist, for example, A and/or B can include: only A exists, both A and B exist, and only B exists. In addition, the character "/" herein generally indicates an "or" relationship between the associated objects.

In the description of the embodiments of the disclosure, the term "a plurality of" means two or more (including two), similarly the term "a plurality of groups" means two or more groups (including two groups), and the term "a plurality of pieces" means two or more pieces (including two pieces).

In the descriptions of the embodiments of the disclosure, it should be understood that the orientation or positional relationships indicated by the technical terms "centre", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc. are based on the orientation or positional relationships shown in the drawings and are merely intended to ease of description of the embodiments of the disclosure and simplification of the description, rather than indicating or implying that the devices or elements referred to must have a specific orientation or be constructed and operated in a specific orientation, and therefore cannot be construed as limiting the embodiments of the disclosure.

In the description of the embodiments of the disclosure, unless otherwise explicitly specified and defined, the technical terms such as "mounting", "connecting", "connection", and "fixing" should be interpreted in a broad sense, for example, they may be a fixed connection, a detachable connection, or integration; may also be a mechanical connection or an electrical connection; or may be a direct connection or an indirect connection by means of an intermediate medium, or may be internal communication between two elements or interaction between the two elements. For those of ordinary skills in the art, the specific meanings of the above terms in the embodiments of the disclosure may be construed according to specific circumstances.

A chip substrate and a chip cover of a microfluidic chip jointly form a liquid movement space, where the height of the liquid movement space, i.e., the gap between the lower surface of the hydrophobic layer of the chip cover and the upper surface of the hydrophobic layer of the chip substrate, is crucial to liquid control. The gap needs to maintain good uniformity throughout the chip, otherwise the liquid area may change due to the non-uniformity of the gap, causing the liquid to be unable to match the electrode and thus resulting in failure of control on liquid.

The embodiments of the disclosure will be further described with reference to the drawings, but the disclosure is not limited to the following embodiments.

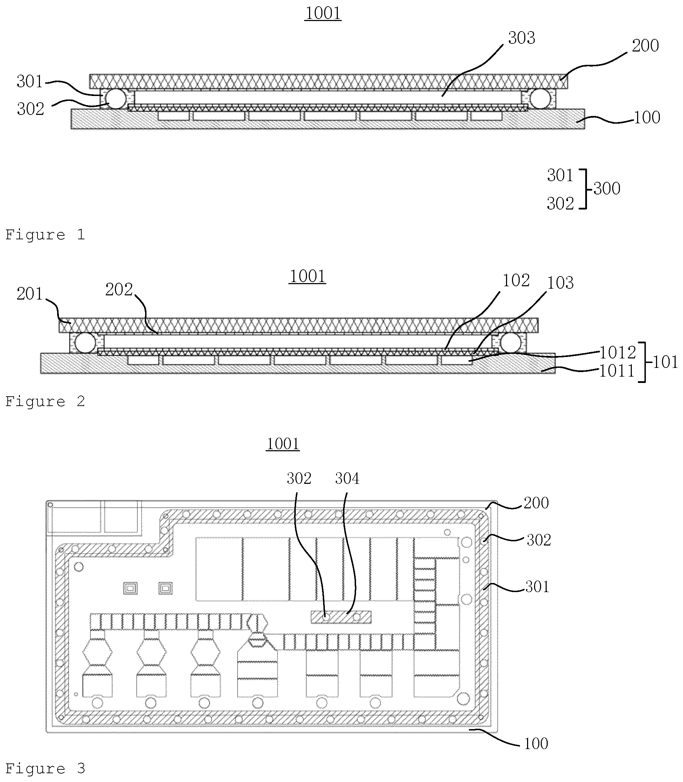

As shown in FIG. 1, in a first aspect of the disclosure, some embodiments provide a microfluidic chip 1001, including a first substrate 100 and a second substrate 200 arranged facing and spaced apart from each other, and a gap control layer 300 located between the first substrate 100 and the second substrate 200. The gap control layer 300 includes an adhesive line 301 and a plurality of gap beads 302 located in the adhesive line 301. The plurality of gap beads 302 are of substantially the same size and are arranged at intervals.

It can be understood that the gap beads are, for example, hard spheres, and may be made of metal, such as steel, gold or titanium. Being of substantially the same size includes the case where the gap beads have the same nominal sizes but have allowable errors caused by manufacturing or machining accuracy. The plurality of gap beads being of the same size should still be regarded as being within the range of substantially the same size as defined in this embodiment, which should be included within the scope of protection of this embodiment.

Providing the plurality of gap beads arranged at intervals in the adhesive line between the first substrate and the second substrate enables control of a gap between the first substrate and the second substrate based on the size of the gap beads. Since the dimensional uniformity of the gap beads can be ensured by means of improving the machining accuracy, the dimensional uniformity of the gap between the first substrate and the second substrate can be ensured to achieve accuracy control and test analysis of droplets, thereby improving the yield and test accuracy of the microfluidic chip.

In some embodiments, the first substrate 100 includes a hydrophobic dielectric functional layer 102, the adhesive line 301 is arranged along an outer edge of the hydrophobic dielectric functional layer 102, and the outer edge of the hydrophobic dielectric functional layer 102 falls within the range of the adhesive line 301.

In some embodiments, the gap beads 302 are arranged outside the outer edge of the hydrophobic dielectric functional layer 102. This avoids causing the gap between the first substrate and the second substrate to have a non-uniform height due to the non-uniform thickness of the hydrophobic dielectric functional layer 102.

In some embodiments, the first substrate 100 further includes a circuit board 101. For example, as shown in FIGS. 1 and 2, the first substrate 100 includes a circuit board 101 and a hydrophobic dielectric functional layer 102 arranged sequentially from the bottom up. Part of the bottom of the adhesive line 301 is arranged on the hydrophobic dielectric functional layer, and the other part thereof is arranged on the circuit board 101, such that the outer edge of the hydrophobic dielectric functional layer 102 falls within the range of the adhesive line 301. The adhesive line 301 is used to reduce the risk of shedding of the hydrophobic dielectric functional layer due to immersion in liquid while bonding the circuit board 101 to the second substrate 200.

As shown in FIGS. 1 and 2, the second substrate 200 includes a conductive cover plate 201 and a hydrophobic layer 202 arranged sequentially from the top down. Part of the top of the adhesive line 301 is in contact with the conductive cover plate 201, and the other part thereof is in contact with the hydrophobic layer 202. Thus, the adhesive line 301 bonds the conductive cover plate 201 to the circuit board 101, and a droplet movement space 303 is formed in an area enclosed by the adhesive line 301 between the hydrophobic dielectric functional layer 102 and the hydrophobic layer 202. In addition, the adhesive line 301 prevents the hydrophobic layer and the hydrophobic dielectric functional layer from being immersed in liquid at the outer edge.

As shown in FIGS. 1 and 2, the gap beads 302 are placed outside the outer edges of the hydrophobic dielectric functional layer 102 and the hydrophobic layer 202, which avoids the non-uniform height of the gap between the hydrophobic dielectric functional layer 102 and the hydrophobic layer 202 caused by the non-uniform thickness of the gap between them.

Exemplarily, the circuit board 101 includes a substrate 1011 and an electrode 1012 located on the substrate 1011. The substrate is used to support other functional film layers of the microfluidic chip and is usually made of a nonconductive material, such as plastic, glass, or a PCB substrate. The electrode may be arranged according to the flow path design and the test function of the microfluidic chip, the electrode may be made of a conductive material, for example, a metallic material such as copper, gold, silver or titanium, or a transparent conductive material such as indium tin oxide (ITO), and the electrode may be prepared by means of an industrial printed circuit board process. The conductive cover plate may be made of indium tin oxide (ITO) plated glass or PET, etc. The hydrophobic dielectric functional layer is used to insulate the electrode from the liquid to avoid conduction of current to the liquid; and the hydrophobic dielectric functional layer is also used together with the hydrophobic layer to provide a smooth surface for liquid movement to reduce movement resistance. The hydrophobic dielectric functional layer may be a single-layer functional film layer, or a multi-layer functional film layer formed by stacking a dielectric layer and a hydrophobic layer. The hydrophobic layer may be made of a fluoride coating with hydrophobic properties, such as Teflon and Cytop.

The droplet movement space is arranged between the hydrophobic dielectric functional layer 102 of the first substrate 100 and the hydrophobic layer 202 of the second substrate 200, which can reduce the surface tension of the droplet to enable the droplet to move accurately under the control of the electrode, thereby improving the test efficiency.

In some embodiments, as shown in FIG. 2, the hydrophobic dielectric functional layer 102 is a hydrophobic dielectric composite layer provided in a single layer, and the hydrophobic dielectric composite layer is bonded to the surface, close to the second substrate 200, of the electrode 1012 on the substrate 1011 by means of an adhesive layer 103.

Exemplarily, the hydrophobic dielectric composite layer is a polytetrafluoroethylene (PTFE) film, a fluorinated ethylene propylene (FEP) film or the like.

The functions of a hydrophobic layer and a dielectric layer are achieved by a layer of film, such that the number and thickness of the film layers on the surface of the electrode are reduced, which shortens the time for preparation of the film layer so as to avoid affecting the movement and test of the droplet due to deterioration of flatness caused by stacking of multiple film layers.

In some embodiments, as shown in FIGS. 3 to 5, the hydrophobic dielectric functional layer 102 has a first pattern 1021, the hydrophobic layer 202 has a second pattern 2021 that is a mirror image of the first pattern 1021, and the first pattern 1021 and the second pattern 2021 exactly match each other after the first substrate 100 and the second substrate 200 are aligned, and thus jointly define the area of the droplet movement space.

It can be understood that the first pattern 1021 and the second pattern 2021 are patterns formed by the remaining film layer, and that no film layer is retained outside the outer boundaries of the first pattern 1021 and the second pattern 2021. The first pattern 1021 may be prepared by means of laser engraving or punching, and the second pattern 2021 may be prepared by means of mask-spraying.

An area of the droplet movement space can be defined by means of providing the first pattern 1021 and the second pattern 2021 that are mirror images of each other, and an area of the adhesive line is reserved outside the droplet movement space, which facilitates guiding the subsequent adhesive dispensing to prevent insufficient sealing caused by leakage of adhesive.

In some embodiments, as shown in FIG. 3, the adhesive line 301 is arranged along an outer edge of the first pattern 1021 of the hydrophobic dielectric functional layer 102, and the outer edge of the hydrophobic dielectric functional layer 102 falls within the range of the adhesive line 301.

The adhesive line 301 is arranged along the outer edge of the hydrophobic dielectric functional layer 102 to allow the liquid movement space to form a sealed chamber, and also the outer edge of the hydrophobic dielectric functional layer 102 falls within the area of the adhesive line 301, such that the adhesive line 301 can seal the edge of the hydrophobic dielectric functional layer 102, which avoids affecting the test effect due to leakage of medium oil or reaction reagents or due to entry of external impurities and also avoids shedding of the hydrophobic dielectric functional layer due to immersion in liquid, thereby improving the stability of quality of the microfluidic chip.

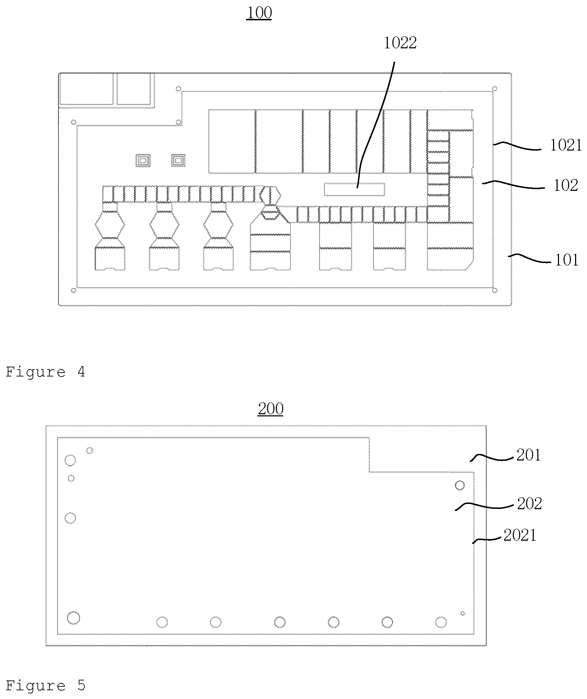

In some embodiments, as shown in FIGS. 3 and 4, the gap control layer 300 further includes at least one support adhesive block 304 located within the outer edge of the hydrophobic dielectric functional layer 102 and abutting against the first substrate 100 and the second substrate 200, with a projection of the at least one support adhesive block 304 on the first substrate 100 being staggered with the first pattern 1021 and the electrode 1012.

Exemplarily, as shown in FIG. 3, the support adhesive block 304 is arranged in the centre of the microfluidic chip 1001 or at another location, and one or multiple support adhesive blocks may be provided.

The support adhesive block 304 is, for example, an adhesive block having certain supporting and bonding capacities, and may also be an adhesive block formed by placing a support (e.g., a gap bead) in an adhesive. The support adhesive block is arranged in the droplet movement space, which can form better support between the first substrate 100 and the second substrate 200, such that the microfluidic chip 1001 receives force more uniformly and has a more stable structure, thereby prolonging the service life of the microfluidic chip. The support adhesive block 304 is staggered with the first pattern 1021 and the electrode 1012, which can avoid affecting the movement of the droplets to ensure the accuracy of the droplet movement control.

In some embodiments, the hydrophobic dielectric functional layer 102 further has a third pattern 1022. The third pattern 1022 is at least one hollowed-out area for accommodating the support adhesive block 304, and at least one gap bead 302 is arranged in any one of the support adhesive blocks 304.

The hollowed-out area is formed on the hydrophobic dielectric functional layer 102 to arrange the support adhesive block 304, and the gap bead 302 is placed in the support adhesive block 304, which can provide better support for the microfluidic chip 1001, especially for the middle area of the droplet movement space, to avoid affecting the uniformity of height of the gap caused by the formation of bulge due to deformation of the middle of the first substrate 100 in the droplet movement space to some extent.

In some embodiments, the gap bead 302 located in the support adhesive block 304 is of substantially the same size as the gap bead 302 located in the adhesive line 301.

It can be understood that the hydrophobic layer is nano-scale in thickness and is not a rigid coating, and the affection of its thickness on the height of the gap between the first substrate 100 and the second substrate 200 can be negligible. Setting the size of the gap bead 302 in the support adhesive block 304 to be substantially the same as the size of the gap bead 302 in the adhesive line 304 is conducive to controlling the height of the gap at the position where the support adhesive block 304 is located to be consistent with the size of the gap bead 302 and thus be consistent with the height of the gap at other positions of the microfluidic chip 1001, which further improves the uniformity of height of the gap while applying uniform force to the microfluidic chip 1001 so as to prevent affecting the uniformity of height of the gap caused by deformation of the middle of the substrate in the droplet movement space. The arrangement of the support adhesive block 304 staggered with the electrode 1012 can also prevent the gap bead 302 from being in contact with the electrode 1012.

Further, the edge of the hollowed-out area may partially or completely fall into the area of the support adhesive block 304, such that the edge of the hollowed-out area can be partially or completely sealed to prevent liquid leakage, thereby improving the sealing performance throughout the microfluidic chip 1001.

In some embodiments, as shown in FIG. 3, projections of all the gap beads 302 (including the gap beads arranged in the adhesive line 301 and in the support adhesive block 304) on the first substrate 100 are staggered with a projection of the hydrophobic dielectric functional layer 102 on the first substrate 100, that is, the gap beads 302 are placed outside the hydrophobic dielectric functional layer 102.

In order to ensure the uniformity of height of the gap, the dimensional accuracy of the gap beads 302 is required to be relatively high, and the sum of the thickness of the hydrophobic dielectric functional layer 102 and the thickness of the adhesive layer 103 is a value that cannot be easily ignored. If some of the gap beads 302 are in contact with the hydrophobic dielectric functional layer 102 and some are not in contact with the hydrophobic dielectric functional layer 10, the corresponding gap heights cannot be kept consistent. In particular, since the electrode 1012 is usually arranged on the surface of the substrate 1011 in a patterned form, it is often difficult to maintain a high level of surface flatness of the hydrophobic dielectric functional layer 102 arranged on the surface of the electrode 1012, and thus it is also difficult to well control the gap error when the gap beads 302 are arranged on the surface of the hydrophobic dielectric functional layer 102. The substrate 1011 is relatively simple and accurate to fabricate, which can well meet the accuracy requirements, and can also well achieve the uniformity of the gap height during arrangement of the gap beads 302.

In some embodiments, the gap bead 302 has a diameter of 800 ± 5 microns.

In some embodiment, the droplet movement space has a height greater than or equal to 710 microns and less than or equal to 740 microns.

According to the requirement on the test accuracy and the need of the droplet flux of the microfluidic chip 1001, selecting an appropriate size of the gap bead and an appropriate tolerance range can not only meet the functional needs of the microfluidic chip but also consider both the manufacturing cost and the manufacturing process, thereby improving the economic efficiency of mass production.

In some embodiments, the plurality of gap beads 302 may be evenly distributed, that is, the adjacent gap beads 302 are spaced at approximately equal distances. The evenly distributed gap beads 302 are more conducive to maintaining the uniformity of the gap at various positions to avoid affecting the droplet control due to the non-uniformity of the gap.

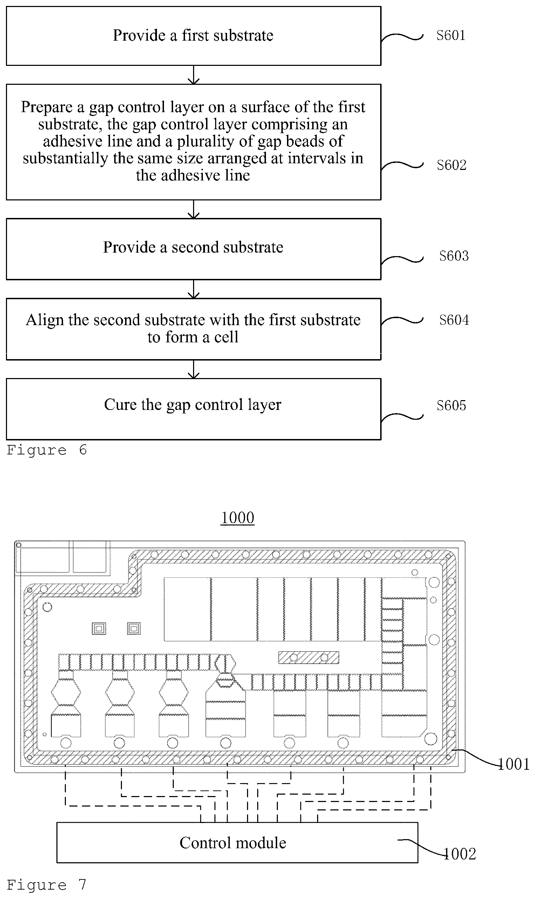

In a second aspect of the disclosure, an embodiment provides a method for preparing a microfluidic chip. As shown in FIG. 6, the preparation method includes:
S601: providing a first substrate 100;
S602: preparing a gap control layer 300 on a surface of the first substrate 100, where the gap control layer 300 includes an adhesive line 301 and a plurality of gap beads 302 of substantially the same size arranged at intervals in the adhesive line 301;
S603: providing a second substrate 200;
S604: placing the second substrate 200 on the gap control layer 300 for alignment with the first substrate 100 to form a cell; and
S605: curing the gap control layer 300.

Exemplarily, curing the gap control layer 300 may be implemented by curing an applied adhesive by means of photocuring, thermal curing, or other practicable curing methods.

Providing the plurality of gap beads of substantially the same or similar size arranged at intervals in the adhesive line allows for highly accurate control of the gap between the first substrate and the second substrate, thereby improving the manufacturing accuracy of the microfluidic chip to ensure the controllability of droplet movement and the accuracy of the test result.

In some embodiments, as shown in FIGS. 1 to 3, S601 includes:
providing a circuit board 101, and
preparing a hydrophobic dielectric functional layer 102 on the circuit board 101.
Providing a second substrate 200 includes:
   providing a conductive cover plate 201; and
   preparing a hydrophobic layer 202 on the conductive cover plate 201.

In some embodiments, S604 includes:
covering the second substrate 200 over the gap bead 302 of the gap control layer 300 in such a way that the side of the second substrate where the hydrophobic layer 202 is located faces the side of the first substrate 100 where the hydrophobic dielectric functional layer 102 is located, a droplet movement space 303 being formed in an area enclosed by the adhesive line 301 between the hydrophobic dielectric functional layer 102 and the hydrophobic layer 202.

Exemplarily, as shown in FIG. 1, the circuit board 101 includes a substrate 1011 and an electrode 1012 located on the substrate 1011. The substrate 1011 is configured to support other functional film layers of the microfluidic chip 1001.

Separately preparing the first substrate 100 and the second substrate 200 and then aligning them to form a cell can improve the production efficiency of the microfluidic chip 1001, covering the second substrate 200 over the gap beads 302 can ensure the dimensional uniformity of the gap, and the droplet movement space being located between the hydrophobic dielectric functional layer 102 and the hydrophobic layer 202 after forming a cell enables the droplets to move smoothly, thereby improving the droplet test efficiency.

In some embodiments, dispensing an adhesive along a surface of one side of the first substrate 100 to form an adhesive line 301 includes:
dispensing an adhesive along an outer edge of a hydrophobic dielectric functional layer 102 on a surface of one side of the first substrate 100 to form an adhesive line 301, the outer edge of the hydrophobic dielectric functional layer 102 falling within the range of the adhesive line 301.

The adhesive line 301 is arranged along the outer edge of the hydrophobic dielectric functional layer 102 to allow the liquid movement space to form a sealed chamber, and also the outer edge of the hydrophobic dielectric functional layer 102 falls within the area of the adhesive line 301, such that the adhesive line 301 can seal the edge of the hydrophobic dielectric functional layer 102, which avoids affecting the test effect due to leakage of medium oil or reaction reagents or due to entry of external impurities, thereby improving the stability of quality of the microfluidic chip 1001. In addition, this can also prevent the hydrophobic dielectric functional layer 102 from shedding due to immersion in liquid.

In some embodiments, preparing a hydrophobic dielectric functional layer 102 on the circuit board 101 includes:
preparing a hydrophobic dielectric functional layer 102 on a surface of one side of the circuit board 101 where an electrode 1012 is provided, and
patterning the hydrophobic dielectric functional layer 102.

For example, first, a surface of one side of the circuit board 101 where the electrode 1012 is provided is evenly coated with a layer of adhesive, a surface of one side of the circuit board 101 where the electrode 1012 is provided is covered, by means of a coating process, with a film for preparing the hydrophobic dielectric functional layer 102, and the film is engraved into a desired shape, such as the first pattern and the third pattern, by means of laser engraving or the like, so as to form the patterned hydrophobic dielectric functional layer 102.

Optionally, the patterned hydrophobic dielectric functional layer 102 is prepared by means of other processes. For example, a film for preparing the hydrophobic dielectric functional layer 102 is provided, the film is punched and cut into the described shape by means of a punching and cutting process or the like to obtain a patterned hydrophobic dielectric functional layer 102, and then the hydrophobic dielectric functional layer 102 is bonded to a surface of one side of the circuit board 101 where the electrode 1012 is provided.

In some embodiments, preparing a hydrophobic layer 202 on the conductive cover plate 201 includes:
preparing a hydrophobic layer 202 on a surface of one side of the conductive cover plate 201, an outer edge of the hydrophobic layer being a mirror image of an outer edge of a pattern of the hydrophobic dielectric functional layer 102, and the hydrophobic layer and the pattern of the hydrophobic dielectric functional layer 102 jointly defining the area of the droplet movement space.

An area of the droplet movement space can be defined by means of providing the first pattern 1021 and the second pattern 2021 that are mirror images of each other, and an area of the adhesive line is reserved outside the droplet movement space, which facilitates guiding the subsequent adhesive dispensing to prevent insufficient sealing caused by leakage of adhesive.

For example, the hydrophobic layer 202 is prepared by a mask-spraying process. That is, the hydrophobic layer 202 is formed by spraying, with part of the conductive cover plate 201 being masked, such that the outer edge of the cured hydrophobic layer 202 is a mirror image of the outer edge of the pattern of the hydrophobic dielectric functional layer 102.

In some embodiments, preparing a gap control layer 300 on the surface of the first substrate 100 includes:
dispensing an adhesive along an edge of the first pattern 1021 of the first substrate 100 to form an adhesive line 301; and
placing a plurality of gap beads 302 at intervals in the adhesive line 301.

Compared with the process of first mixing the gap beads 302 with adhesive and then applying the mixture to the surface of the first substrate 100, it is more conducive to ensuring the uniformity of the gap by first dispensing an adhesive on the surface of the first substrate 100 to form the adhesive line 301 and then placing the gap beads 302 of substantially the same size in the adhesive line 301 at intervals. On the one hand, the position of the adhesive strip can provide positioning for placement of the gap beads, and the viscosity of the adhesive strip can ensure that the gap beads have no position shift after the placement of the gap beads 302, so as to enable the gap beads to be roughly stably distributed within the range of the entire adhesive line. On the other hand, the positions of the gap beads 302 can be arranged subjectively and can be flexibly adjusted as needed, which avoids being unable to control the arrangement positions of the gap beads 302 during mixed application, thereby improving the uniformity of the gap of the droplet movement space throughout the microfluidic chip 1001.

In some embodiments, as shown in FIGS. 2 and 3, the edge of the first pattern 1021 in the hydrophobic dielectric functional layer 102 falls within the range of the adhesive line 301, and the projections of the gap beads 302 on the first substrate 100 are located outside the range of the hydrophobic dielectric functional layer 102.

By means of covering the edge of the first pattern 1021 in the hydrophobic dielectric functional layer 102 with the adhesive line 301, the edge position can be well sealed to avoid shedding of the hydrophobic dielectric functional layer 102 due to the edge being exposed to the droplets during patterning and also prevent the droplets from leaking and then coming into contact with the electrode 1012. Arranging the gap beads 302 outside the range of the hydrophobic dielectric functional layer 102 can ensure that the gap is not affected by the thickness of the film layer, thereby improving the uniformity of the gap of the microfluidic chip 1001.

In some embodiments, preparing a hydrophobic dielectric functional layer 102 on the circuit board 101 further includes: patterning the hydrophobic dielectric functional layer 102 to form a first pattern 1021 and a third pattern 1022 that is staggered with the first pattern 1021 and the electrode 1012, the third pattern 1022 being at least one hollowed-out area. The hydrophobic layer 202 has a second pattern 2021. The second pattern 2021 is a mirror image of the first pattern 1021 and defines the droplet movement space with the first pattern 1021.

In some embodiments, preparing a gap control layer 300 further includes:
dispensing an adhesive in the at least one hollowed-out area to form at least one support adhesive block 304, and
placing at least one gap bead 302 in any one of the at least one support adhesive block 304.

In some embodiments, the gap bead 302 located in the support adhesive block 304 is of substantially the same size as the gap bead 302 located in the adhesive line 301.

The hollowed-out area is formed on the hydrophobic dielectric functional layer 102 to arrange the support adhesive block 304, and the gap bead 302 is placed in the support adhesive block 304, which can provide better support for the microfluidic chip 1001, especially for the middle area of the droplet movement space, to avoid affecting the uniformity of height of the gap caused by the formation of bulge due to deformation of the middle of the first substrate 100 in the droplet movement space to some extent. Setting the size of the gap bead 302 in the support adhesive block 304 to be substantially the same as the size of the gap bead in the adhesive line 301 is conducive to controlling the height of the gap at the position where the support adhesive block 304 is located to be substantially consistent with the size of the gap bead 302 and thus be substantially consistent with the height of the gap at other positions of the microfluidic chip 1001, which further ensures the uniformity of height of the gap while applying uniform force to the microfluidic chip. The arrangement of the support adhesive block 304 staggered with the electrode 1012 can also prevent the gap bead 302 from being in contact with the electrode 1012.

In some embodiments, an edge of the third pattern 1022 is at least partially located within the range of the at least one corresponding support adhesive block 304, and a projection of the gap bead 302 on the first substrate 100 is located outside the range of the hydrophobic dielectric functional layer 102.

Covering at least part of the edge of the third pattern 1022 based on the sealing performance of the support adhesive block 304 can achieve sealing of the patterned edge of the hydrophobic dielectric functional layer 102, and arranging the gap beads 302 at positions staggered with the hydrophobic dielectric functional layer 102 can avoid non-uniformity of height of the gap due to the different gap beads 302 being staggered in position, and can also avoid affecting the uniformity of the gap due to the low surface accuracy of the hydrophobic dielectric functional layer 102.

In some embodiments, prior to curing the gap control layer 300, the method further includes: applying a preset pressure to outer surfaces of the first substrate 100 and the second substrate 200.

The preset pressure is applied to the outer surfaces of the first substrate 100 and the second substrate 200 after the first substrate 100 and the second substrate 200 are aligned and prior to the gap control layer 300 is cured. In this way, when a small number of gap beads 302 are shifted in position and come into contact with the hydrophobic dielectric functional layer 102, these gap beads 302 will be pressed to move away from the hydrophobic dielectric functional layer 102 under the action of the preset pressure so as to improve the uniformity of the gap between the first substrate 100 and the second substrate 200 throughout the microfluidic chip 1001.

In a third aspect of the disclosure, an embodiment further provides a microfluidic system 1000. As shown in FIGS. 1 and 7, the microfluidic system 1000 includes a microfluidic chip 1001 and a control module 1002. The microfluidic chip 1001 is the microfluidic chip as described in any one of the foregoing embodiments or a microfluidic chip made by the preparation method for a microfluidic chip. The control module 1002 is electrically connected to the microfluidic chip 1001 to control an electrical signal provided to the microfluidic chip 1001.

It should be understood that controlling the electrical signal provided to the microfluidic chip 1001 may refer to controlling an electrical signal provided to the first substrate 100 in the microfluidic chip 1001, controlling an electrical signal provided to the second substrate 200, or controlling both electrical signals provided to the first substrate 100 and to the second substrate 200.

The electrical signals provided to the first substrate 100 and the second substrate 200 of the microfluidic chip 1001 are controlled by the control module 1002, and then the potential difference between the first substrate 100 and the second substrate 200 is controlled, so as to implement multiple functions such as driving, separation and test of the droplets in the microfluidic chip 1001, thereby improving the controllability and expanding the application range of the microfluidic system 1000.

It should be finally noted that the foregoing embodiments are merely used for illustrating rather than limiting the technical solutions of the disclosure. Although the disclosure has been illustrated in detail with reference to the foregoing embodiments, it should be understood by those of ordinary skill in the art that the technical solutions described in the foregoing embodiments may still be modified, or some or all of the technical features thereof may be equivalently substituted; and such modifications or substitutions do not make the essence of the corresponding technical solution depart from the scope of the technical solutions of the embodiments of the disclosure, and should fall within the scope of the claims and the specification of the disclosure. In particular, the technical features mentioned in the embodiments can be combined in any manner, as long as there is no structural conflict. The disclosure is not limited to the specific embodiments disclosed herein but includes all the technical solutions that fall within the scope of the claims.

## Claims

1. A microfluidic chip, **characterised by** comprising:
a first substrate,
a second substrate arranged facing and spaced apart from the first substrate, and
a gap control layer located between the first substrate and the second substrate,
wherein the gap control layer comprises an adhesive line and a plurality of gap beads of substantially the same size arranged at intervals in the adhesive line.

2. The microfluidic chip according to claim 1, **characterised in that** the first substrate comprises a hydrophobic dielectric functional layer, the adhesive line is arranged along an outer edge of the hydrophobic dielectric functional layer, and the outer edge of the hydrophobic dielectric functional layer falls within a range of the adhesive line.

3. The microfluidic chip according to claim 2, **characterised in that** the gap beads are arranged outside the outer edge of the hydrophobic dielectric functional layer.

4. The microfluidic chip according to claim 2 or 3, **characterised in that**
the first substrate further comprises a circuit board comprising a substrate and an electrode located on the substrate, the hydrophobic dielectric functional layer being arranged on a surface of the electrode close to the second substrate; and
the second substrate comprises a conductive cover plate and a hydrophobic layer facing each other, a droplet movement space being formed between the hydrophobic dielectric functional layer and the hydrophobic layer.

5. The microfluidic chip according to claim 4, **characterised in that** the hydrophobic dielectric functional layer is a single-layer hydrophobic dielectric composite layer that is bonded to the surface of the electrode close to the second substrate by means of an adhesive layer.

6. The microfluidic chip according to claim 4, **characterised in that** the hydrophobic dielectric functional layer has a first pattern, and the hydrophobic layer has a second pattern that is a mirror image of the first pattern, the first pattern and the second pattern jointly defining the droplet movement space.

7. The microfluidic chip according to claim 2 or 3, **characterised in that** the gap control layer further comprises at least one support adhesive block located within the outer edge of the hydrophobic dielectric functional layer and abutting against the first substrate and the second substrate, with a projection of the at least one support adhesive block on the first substrate being staggered with the electrode on the first substrate.

8. The microfluidic chip according to claim 7, **characterised in that** the hydrophobic dielectric functional layer further has a third pattern that is at least one hollowed-out area for accommodating the at least one support adhesive block, and at least one gap bead is provided in any one of the at least one support adhesive block.

9. The microfluidic chip according to claim 8, **characterised in that** the gap bead located in the at least one support adhesive block is of substantially the same size as the gap beads located in the adhesive line.

10. The microfluidic chip according to claim 9, **characterised in that** an edge of the third pattern is at least partially located within a range of at least one corresponding support adhesive block, and an orthographic projection of the gap bead arranged in any one of the at least one support adhesive block on the first substrate is located outside a range of the hydrophobic dielectric functional layer.

11. The microfluidic chip according to claim 4, **characterised in that** the gap bead has a diameter of 800 ± 5 microns.

12. The microfluidic chip according to claim 11, **characterised in that** the droplet movement space has a height greater than or equal to 710 microns and less than or equal to 740 microns.

13. A method for preparing a microfluidic chip, **characterised in that** the method comprises:
providing a first substrate,
preparing a gap control layer on a surface of one side of the first substrate, wherein the gap control layer comprises an adhesive line and a plurality of gap beads of substantially the same size arranged at intervals in the adhesive line,
providing a second substrate,
placing the second substrate on the gap control layer for alignment with the first substrate to form a cell, and
curing the gap control layer.

14. The method according to claim 13, **characterised in that** preparing a gap control layer on a surface of one side of the first substrate comprises:
dispensing an adhesive along a surface of one side of the first substrate to form an adhesive line; and
placing a plurality of gap beads of substantially the same size at intervals in the adhesive line.

15. The method according to claim 14, **characterised in that**
providing a first substrate comprises:
providing a circuit board, and
preparing a hydrophobic dielectric functional layer on the circuit board;
providing a second substrate comprises:
providing a conductive cover plate, and
preparing a hydrophobic layer on the conductive cover plate; and
placing the second substrate on the gap control layer for alignment with the first substrate to form a cell comprises:
covering the second substrate over the gap beads of the gap control layer in such a way that the side of the second substrate where the hydrophobic layer is located faces the side of the first substrate where the hydrophobic dielectric functional layer is located, a droplet movement space being formed between the hydrophobic dielectric functional layer and the hydrophobic layer.

16. The method according to claim 14 or 15, **characterised in that** dispensing an adhesive along a surface of one side of the first substrate to form an adhesive line comprises:
dispensing an adhesive along an outer edge of a hydrophobic dielectric functional layer on a surface of one side of the first substrate to form an adhesive line, the outer edge of the hydrophobic dielectric functional layer falling within a range of the adhesive line.

17. The method according to claim 16, **characterised in that** the gap beads are arranged outside the outer edge of the hydrophobic dielectric functional layer.

18. The method according to claim 15, **characterised in that**
preparing a hydrophobic dielectric functional layer on the circuit board comprises:
preparing a film for forming a hydrophobic dielectric functional layer, on a surface of one side of the circuit board where an electrode is provided, and
patterning the film to form the hydrophobic dielectric functional layer; and
preparing a hydrophobic layer on the conductive cover plate comprises:
preparing a hydrophobic layer on a surface of one side of the conductive cover plate, an outer edge of a pattern of the hydrophobic layer being a mirror image of an outer edge of a pattern of the hydrophobic dielectric functional layer.

19. The method according to claim 18, **characterised in that**
preparing a hydrophobic dielectric functional layer on the circuit board further comprises:
forming the hydrophobic dielectric functional layer having a first pattern and a third pattern that is staggered with the first pattern and the electrode, the third pattern being at least one hollowed-out area;
preparing a hydrophobic layer on the conductive cover plate comprises:
forming the hydrophobic layer having a second pattern that is a mirror image of the first pattern and that defines the droplet movement space with the first pattern; and
preparing a gap control layer further comprises:
dispensing an adhesive in the at least one hollowed-out area to form at least one support adhesive block, and
placing at least one gap bead in any one of the at least one support adhesive block.

20. The method according to claim 19, **characterised in that** the gap bead located in the at least one support adhesive block is of substantially the same size as the gap beads located in the adhesive line.

21. The method according to claim 19, **characterised in that** an edge of the third pattern is at least partially located within a range of at least one corresponding support adhesive block, and a projection of the gap bead arranged in the at least one support adhesive block on the first substrate is located outside a range of the hydrophobic dielectric functional layer.

22. The method according to any one of claims 13 to 15, **characterised in that** prior to curing the gap control layer, the method further comprises:
applying a preset pressure to an outer surface of the first substrate and an outer surface of the second substrate.

23. A microfluidic system, **characterised by** comprising a control module, and a microfluidic chip according to any one of claims 1 to 12 or a microfluidic chip prepared by a method according to any one of claims 13 to 22, wherein
the control module is electrically connected to the microfluidic chip to control electrical signals provided to the microfluidic chip.
